# EUROPEAN PATENT APPLICATION

(11) **EP 3 767 379 A1**
(43) Date of publication of application: **20.01.2021**
(21) Application number: 18889952.0
(22) Date of filing: 11.12.2018
(51) Int. Cl.: G02F 1/1333

(54) **DISPLAY SUBSTRATE, MANUFACTURING METHOD, DISPLAY PANEL AND DISPLAY DEVICE**

(30) Priority: 14.03.2018 CN 201810209562
(71) Applicant: BOE TECHNOLOGY GROUP CO., LTD., Beijing 100015 (CN); Ordos Yuansheng Optoelectronics Co., Ltd., Ordos, Inner Mongolia 017020 (CN)
(72) Inventor: CHEN, Yanqing, Beijing 100176 (CN); XIE, Jianyun, Beijing 100176 (CN); LI, Wei, Beijing 100176 (CN); WANG, Xuelu, Beijing 100176 (CN); LI, Cheng, Beijing 100176 (CN); GUO, Pan, Beijing 100176 (CN)
(74) Representative: Isarpatent
(86) International application number: PCT/CN2018/120255
(87) International publication number: WO 2019/174334

(57) **Abstract**

A display substrate, a manufacturing method of the display substrate, a display panel and a display device are provided. The display substrate includes a plurality of subpixels arranged at a display region. The display region is provided with a first boundary of a curve-like shape. The display region includes a central region and a peripheral region adjacent to the first boundary. The plurality of subpixels includes a plurality of first subpixels arranged at the peripheral region and a plurality of second subpixels arranged at the central region. At least a part of the first subpixels each have an aperture ratio smaller than that of any of the second subpixels.

## Description

### CROSS-REFERENCE TO RELATED APPLICATION

The present application claims a priority of the Chinese patent application No. 201810209562.5 filed on March 14, 2018, which is incorporated herein by reference in its entirety.

### TECHNICAL FIELD

The present disclosure relates to the field of display technology, in particular to a display substrate, a manufacturing method of the display substrate, a display panel and a display device.

### BACKGROUND

Along with the rapid development of the display technology and smart terminal, a display product has a larger and larger screen-to-body ratio. Taking a full-screen display device or smart wearable device having a large screen-to-body ratio as an example, usually its display region matches its bezel, so the display region is provided with an arc-like boundary (e.g., the display region is provided with four rounded corners).

For a conventional display product, each subpixel is of a rectangular shape, so it is impossible to arrange the subpixels in such a manner as to perfectly match the arc-like boundary of the display region. At this time, such an obvious phenomenon as saw-toothed (or grainy) structure may occur for a display image at the arc-like boundary, and this phenomenon is visible to the naked eyes. Hence, the user experience may be adversely affected.

In view of the above, there is an urgent need to provide a scheme to improve the saw-toothed structure for the display image.

### SUMMARY

In one aspect, the present disclosure provides in some embodiments a display substrate including a plurality of subpixels arranged at a display region. The display region is provided with a first boundary of a curve-like shape. The display region includes a central region and a peripheral region adjacent to the first boundary. The plurality of subpixels includes a plurality of first subpixels arranged at the peripheral region and a plurality of second subpixels arranged at the central region. An aperture ratio of each of at least a part of the first subpixels is smaller than an aperture ratio of any of the second subpixels.

In a possible embodiment of the present disclosure, a second boundary is arranged between the peripheral region and the central region, and a distance between the second boundary and the first boundary is smaller than a predetermined threshold.

In a possible embodiment of the present disclosure, an aperture ratio of each of the first subpixels is smaller than an aperture ratio of any of the second subpixels.

In a possible embodiment of the present disclosure, a distance between each first subpixel and the first boundary is smaller than a distance between each second subpixel and the first boundary.

In a possible embodiment of the present disclosure, the aperture ratios of the first subpixels decrease gradually in a direction from the central region of the display region to the first boundary of the display region.

In a possible embodiment of the present disclosure, the aperture ratios of the first subpixels decrease gradually in a lengthwise direction of the first subpixels.

In a possible embodiment of the present disclosure, the aperture ratios of the first subpixels decrease gradually in a widthwise direction of the first subpixels.

In a possible embodiment of the present disclosure, the first boundary is of an arc-like shape, and the aperture ratios of the first subpixels decrease gradually in a radial direction of the first boundary.

In a possible embodiment of the present disclosure, the at least a part of the first subpixels each include a light-shielding pattern and at least a transparent region surrounded by the light-shielding pattern.

In a possible embodiment of the present disclosure, the at least a part of the first subpixels each include at least two transparent regions each extending in the lengthwise direction of the first subpixel and spaced apart from each other in the widthwise direction of the first subpixel.

In a possible embodiment of the present disclosure, widths of the transparent regions of the at least a part of the first subpixels decrease gradually in the direction from the central region of the display region to the first boundary of the display region.

In a possible embodiment of the present disclosure, the light-shielding pattern is one of a black matrix pattern, a source-drain metal pattern and a gate metal pattern of the display substrate.

In another aspect, the present disclosure provides in some embodiments a method for manufacturing a display substrate. The display substrate includes a plurality of subpixels arranged at a display region. The display region is provided with a first boundary of a curve-like shape. The display region includes a central region and a peripheral region adjacent to the first boundary. The method includes forming first subpixels at the peripheral region and forming second subpixels at the central region. An aperture ratio of each of at least a part of the first subpixels is smaller than an aperture ratio of any of the second subpixels.

In yet another aspect, the present disclosure provides in some embodiments a display panel including the above-mentioned display substrate.

In still yet another aspect, the present disclosure provides in some embodiments a display device including the above-mentioned display panel.

### BRIEF DESCRIPTION OF THE DRAWINGS

Fig.1 is a schematic view showing a display substrate according to one embodiment of the present disclosure;
Fig.2 is another schematic view showing the display substrate according to one embodiment of the present disclosure;
Fig.3a is a schematic view showing first subpixels of the display substrate according to one embodiment of the present disclosure;
Fig.3b is another schematic view showing the first subpixels of the display substrate according to one embodiment of the present disclosure;
Fig.4a is yet another schematic view showing the first subpixels of the display substrate according to one embodiment of the present disclosure; and
Fig.4b is still yet another schematic view showing the first subpixels of the display substrate according to one embodiment of the present disclosure.

### DETAILED DESCRIPTION OF THE EMBODIMENTS

In order to make the objects, the technical solutions and the advantages of the present disclosure more apparent, the present disclosure will be described hereinafter in a clear and complete manner in conjunction with the drawings and embodiments. In the following description, specific details of configurations and assemblies are merely provided to facilitate the understanding of the present disclosure. It should be appreciated that, a person skilled in the art may make further modifications and alternations without departing from the spirit of the present disclosure. In addition, for clarification, any known function and structure will not be described hereinafter.

It should be further appreciated that, such phrases as "one embodiment" and "one of the embodiments" intend to indicate that the features, structures or characteristics are contained in at least one embodiment of the present disclosure, rather than referring to a same embodiment. In addition, the features, structures or characteristics may be combined in any embodiment or embodiments in an appropriate manner.

It should be appreciated that, the following serial numbers do not refer to the order of the steps. Actually, the order shall be determined in accordance with functions and internal logic of the steps, but shall not be construed as limiting the implementation in any form.

An object of the present disclosure is to provide a scheme, so as to solve the problem in the related art where such a phenomenon as saw-toothed structure occurs for a display image caused when a boundary of a display region does not match a shape of each subpixel.

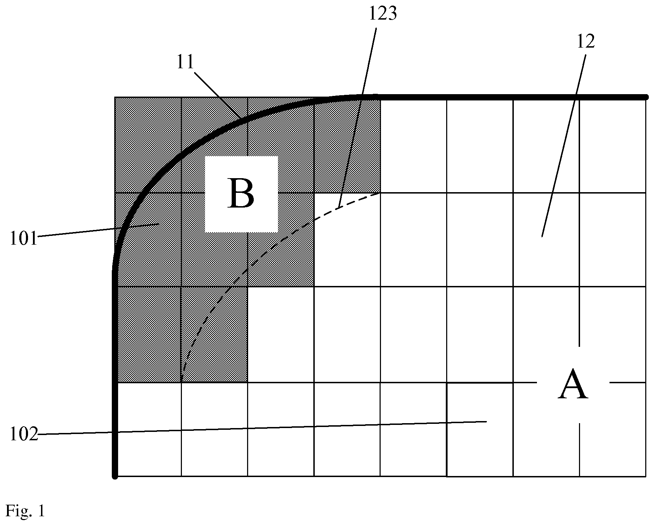

The present disclosure provides in some embodiments a display substrate which, as shown in Fig.1, includes a plurality of subpixels 10 arranged at a display region 12. The display region 12 is provided with a first boundary 11.

For example, the first boundary 11 may be of an arc-like shape that does not match a shape of each subpixel 10. It should be appreciated that, the first boundary 11 may include, or not include, a right-angled portion (e.g., two boundaries intersect to each other to form a right angle).

The plurality of subpixels may include first subpixels and second subpixels other than the first subpixels. A distance between each first subpixel and the first boundary 11 may be smaller than a predetermined threshold. At least a part of the first subpixels (grey boxes in Fig.1) may each have an aperture ratio smaller than that of the second subpixels. The predetermined threshold may be set in accordance with the practical need. For example, the predetermined threshold may be, but not limited to, equal to a length or width of one subpixel. Each first subpixel may be a subpixel, an absolute distance between which and the first boundary 11 is smaller than the predetermined threshold (the absolute distance may be a minimum distance between the first subpixel and the boundary 11). In addition, a region adjacent to the first boundary 11 may be determined in accordance with the predetermined threshold, and all the subpixels at this region may be just the first subpixels.

As shown in Fig. 1, the display region 12 may include a central region A and a peripheral region B adjacent to the first boundary 11. A second boundary 123 may be arranged between the peripheral region B and the central region A. A distance between the second boundary 123 and the first boundary 11 may be smaller than a predetermined threshold. The plurality of subpixels 10 may include the first subpixels 101 arranged at the peripheral region B and the second subpixels 102 arranged at the central region A. The second boundary 123 may be parallel to the first boundary 11, i.e., it may also be of a curve-like shape. The second boundary 123 may also extend along edges of the subpixels and coincide with the edges of the subpixels so as to be of a saw-toothed shape or a step-like shape.

In some embodiments of the present disclosure, each of the plurality of first subpixels 101 may have an aperture ratio smaller than that of any of the second subpixels 102.

According to the display substrate in the embodiments of the present disclosure, through reducing the aperture ratios of the subpixels adjacent to the first boundary of the display region, it is able to weaken the saw-teeth phenomenon for a display image at the display region adjacent to the first boundary, thereby to improve the display quality as well as the user experience.

To be specific, a distance between each first subpixel 101 and the first boundary 11 may be smaller than a distance between each second subpixel 102 and the first boundary 11. In other words, each first subpixel 101 may be arranged adjacent to the first boundary 11, and each second subpixel 102 may be arranged further away from the first boundary 11 of the display region than the first subpixel.

Based on the above design, merely a brightness value at a peripheral portion of the display region may be reduced appropriately, so as to weaken the saw-teeth phenomenon at an edge of the display image. In addition, a brightness value at the other portion of the display region may not be affected, so it is able to display the image normally.

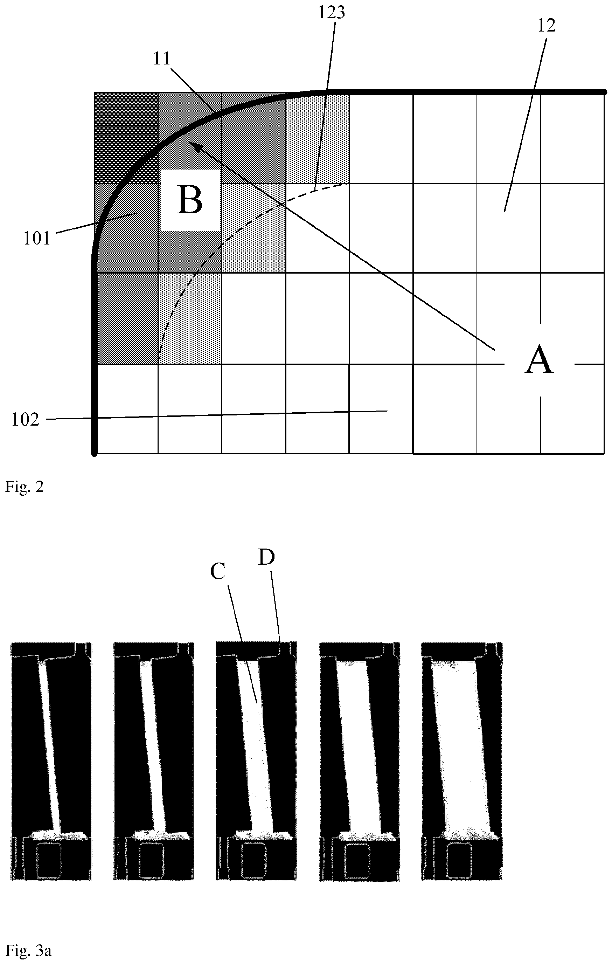

In order to further improve the display quality, as shown in Fig.2, the aperture ratios of the first subpixels 101 may decrease gradually in a direction from the central region A of the display region to the first boundary 11 of the display region (i.e., a direction indicated by an arrow in Fig.2). When the aperture ratios of the first subpixels 101 decrease gradually, the brightness values of the first subpixels 101 may smoothly decrease toward the first boundary 11. In this way, it is able to prevent, to some extent, a change in the brightness value at the peripheral portion of the display image from being recognized by a user, thereby to prevent a display effect from being adversely affected.

The display substrate will be described hereinafter in more details.

In some embodiments of the present disclosure, a light-shielding pattern for shielding each first subpixel may be provided, so as to control the aperture ratio of the first subpixel.

The light-shielding pattern is configured to shield a portion of the first subpixel, and each first subpixel may further include a transparent region surrounded by the light-shielding pattern and configured to display the image.

In actual use, in order not to provide any additional manufacture process and to reduce the manufacture cost, the light-shielding pattern may be at least one of a black matrix pattern, a source-drain metal pattern and a gate metal pattern of the display substrate, or the light-shielding pattern may be manufactured through a same patterning process as the black matrix pattern, the source-drain metal pattern or the gate metal pattern.

Each first subpixel may include one or more transparent regions.

As shown in Fig.3a, each first subpixel merely includes one transparent region C. The five adjacent first subpixels in Fig.3a are shielded by different light-shielding patterns D (a shielded portion of each first subpixel is in black), so they may have different transparent regions C.

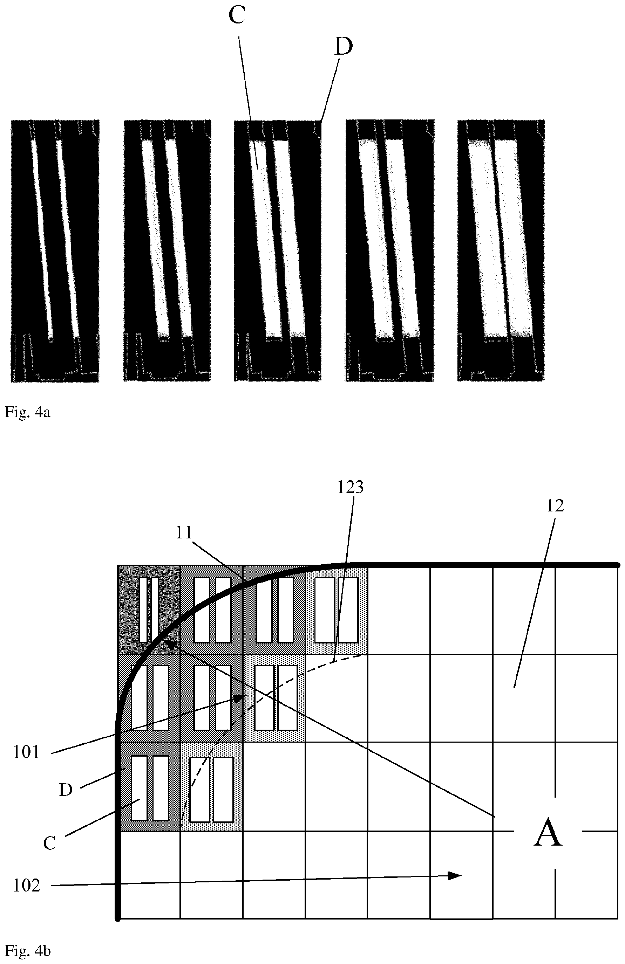

It should be appreciated that, a shape of an opening region (i.e., the transparent region C) of each first subpixel in Figs.3a and 4a is merely for illustrative purposes. Of course, the transparent region C may also be of a rectangular or polygonal shape. In addition, the shape of the transparent region may be similar to a profile of the first subpixel.

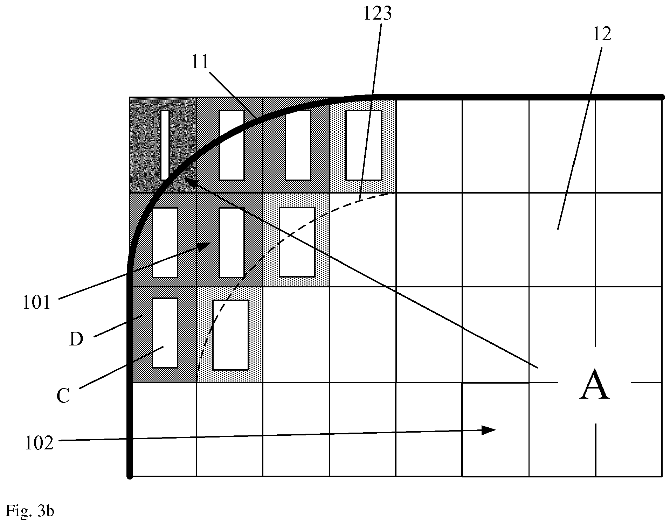

As shown in Fig.3b, widths of the transparent regions C may decrease gradually in the direction from the central region A of the display region to the first boundary 11 of the display region (i.e., a direction indicated by the arrow in Fig.3b). In other words, the first subpixel closer to the first boundary may have a smaller transparent region C and a smaller brightness value.

In a possible embodiment of the present disclosure, as shown in Fig.3b, the aperture ratios of the first subpixels 101 may decrease gradually in a lengthwise direction of each first subpixel 101.

In a possible embodiment of the present disclosure, as shown in Fig.3b, the aperture ratios of the first subpixels 101 may decrease gradually in a widthwise direction of each first subpixel 101.

In a possible embodiment of the present disclosure, as shown in Fig.3b, the first boundary 11 may be of an arc-like shape, and the aperture ratios of the first subpixels 101 may decrease gradually in a radial direction of the first boundary 11.

Based on the structure of the first subpixels in Figs.3a and 3b, the brightness values of the first subpixels may smoothly decrease toward the first boundary, so as to prevent, to some extent, the change in the brightness value at the display region adjacent to the first boundary from being recognized by the user.

In addition, as shown in Figs.4a and 4b, each first subpixel includes at least two transparent regions (in Figs.4a and 4b, two transparent regions are taken as an example). In Figs.4a and 4b, with respect to each first subpixel, the at least two transparent regions C may extend in the lengthwise direction of the first subpixel 101 (the lengthwise direction refers to a direction in which a long side of the first subpixel extends), and spaced apart from each other in the widthwise direction of the first subpixel 101 (the widthwise direction refers to a direction in which a short side of the first subpixel extends). The widths of the transparent regions C may decrease gradually in the direction from the central region A of the display region to the first boundary 11 of the display region (i.e., a direction indicated by an arrow in Fig.4b). In this way, the first subpixel closer to the first boundary may have a smaller transparent region C and a smaller brightness value.

It should be appreciated that, the aperture ratios of the first subpixels 101 may not be limited to decreasing linearly in a certain direction. For example, the aperture ratios of the first subpixels 101 may gradually decrease from 95% of an aperture ratio of the subpixel at the central region, to 80%, 75%, 60% and so on, or from 90%, 80%, 80%, 60% and so on.

As compared with the first subpixels in Figs.3a and 3b, each first subpixel 101 in Figs.4a and 4b is provided with more transparent regions, so as to provide a more uniform light-shielding region between any two adjacent first subpixels and smoothly decrease the brightness values, thereby to further reduce a brightness difference at a peripheral portion of the display image and enable the user to view a more natural display image.

It should be appreciated that, apart from two transparent regions in Figs.4a and 4b, each first subpixel may include more than two transparent regions, which will not be particularly defined herein due to a same principle.

According to the display substrate in the embodiments of the present disclosure, it is able to prevent, to some extent, the occurrence of the sawtooth phenomenon at the peripheral portion of the display image even when the boundary of the display region does not match the shape of the subpixel, thereby to improve the user experience, so the scheme in the embodiments of the present disclosure has a high practical value.

The present disclosure further provides in some embodiments a method for manufacturing a display substrate. The display substrate includes a plurality of subpixels arranged at a display region. The display region is provided with a first boundary. The method includes forming first subpixels and second subpixels. A distance between each first subpixel and the first boundary is smaller than a predetermined threshold. At least a part of the first subpixels each have an aperture ratio smaller than any of the second subpixels.

Obviously, the method may be used to manufacture the above-mentioned display substrate, so the technical effect of the method may refer to that of the display substrate.

In actual use, the method may further include forming a light-shielding pattern on each first subpixel, so as to change the aperture ratio of the first subpixel.

In other words, for each first subpixel whose aperture ratio is smaller than the second subpixel, it may include the light-shielding pattern and at least one transparent region surrounded by the light-shielding pattern. The aperture ratio of the first subpixel may depend on a ratio of an area of the transparent region to an area of the entire first subpixel. In other words, the larger the ratio of the area of the transparent region to the area of the entire first subpixel, the larger the aperture ratio of the first subpixel is and the larger the brightness value is. In contrast, the smaller the ratio of the area of the transparent region to the area of the entire first subpixel, the smaller the aperture ratio of the first subpixel is and the smaller the brightness value is.

In actual use, in order not to provide any additional manufacture process, the non-transparent pattern of the display substrate known in the art, e.g., a black matrix pattern, a source-drain metal pattern or a gate metal pattern, may be reused as the light-shielding pattern, or the light-shielding pattern may be formed through a same patterning process as the non-transparent pattern. Hence, the light-shielding pattern may be formed prior to or subsequent to the formation of a pixel electrode.

When the light-shielding pattern and the source-drain metal pattern are formed through a single patterning process, the formation of the light-shielding pattern will be described as follows.

Before the formation of the pixel electrode, a source-drain metal layer having a thickness of about 2000 to 4000Å may be deposited on a base substrate through magnetron sputtering, thermal evaporation or any other film-forming process. The source-drain metal layer may be made of copper (Cu), aluminium (Al), argentum (Ag), molybdenum (Mo), chromium (Cr), neodymium (Nd), nickel (Ni), manganese (Mn), titanium (Ti), tantalum (Ta) or tungsten (W), or an alloy thereof. The source-drain metal layer may be of a single-layered structure, or a multiple-layered structure e.g., Cu/Mo, Ti/Cu/Ti or Mo/Al/Mo. A photoresist may be applied to the source-drain metal layer, and then exposed with a mask plate, so as to form a photoresist reserved region corresponding to a region where a source electrode, a drain electrode and the light-shielding pattern are located, and a photoresist unreserved region corresponding to the other region. Next, development treatment may be performed, so as to fully remove the photoresist at the photoresist unreserved region, and maintain a thickness of the photoresist at the photoresist reserved region. Then, the source-drain metal layer at the photoresist unreserved region may be etched off through an etching process, and the remaining photoresist may be removed, so as to acquire the drain electrode, the source electrode and the light-shielding pattern.

It should be appreciated that, a principle for manufacturing the light-shielding pattern and the other nontransparent pattern through a single etching process may be the same as that mentioned hereinabove, and thus will not be particularly defined herein.

The present disclosure further provides in some embodiments a display panel including the above-mentioned display substrate.

According to the display panel in the embodiments of the present disclosure, the aperture ratio of the subpixel adjacent to the first boundary of the display region is smaller than that of the other subpixel. As a result, it is able to prevent, to some extent, the occurrence of the sawtooth phenomenon at the peripheral portion of the display image, thereby to improve the display quality as well as the user experience.

It should be appreciated that, the display panel may be applied to any type of display product. For example, it may be of a single-substrate structure (which may be applied to an organic light-emitting diode (OLED) display product), or a structure consisting of two substrates arranged opposite to each other to form a cell (which may be applied to a liquid crystal display (LCD) product).

The present disclosure further provides in some embodiments a display device including the above-mentioned display panel. A technical effect of the display device may refer to that of the display panel.

In actual use, the display device may be any product or member having a display function, e.g., liquid crystal television, liquid crystal display, digital photo frame, mobile phone or flat-panel computer, especially a display product having a large screen-to-body ratio (e.g., a full-screen display device or a smart wearable device). The display region of this type of product is approximately arranged on an entire display surface, so the display region is provided with an arc-like first boundary (e.g., the display region is provided with four rounded corners) which does not match the subpixel of a rectangular shape. According to the display device in the embodiments of the present disclosure, the aperture ratio of the subpixel adjacent to the first boundary of the display region may be reduced. As a result, it is able to prevent, to some extent, the occurrence of the sawtooth phenomenon at the peripheral portion of the display image, thereby to improve the display quality as well as the user experience, so the scheme in the embodiments of the present disclosure has a high practical value.

Unless otherwise defined, all the technical or scientific terms involved in the embodiments of the present disclosure shall have the common meaning understood by a person of ordinary skills. Such a word as "include" may refer to that an element or member before the word include, but not limited to, an element, member or equivalents thereof listed after the word.

The above embodiments are for illustrative purposes only, but the present disclosure is not limited thereto. Obviously, a person skilled in the art may make further modifications and improvements without departing from the spirit of the present disclosure, and these modifications and improvements shall also fall within the scope of the present disclosure.

## Claims

1. A display substrate, comprising a plurality of subpixels arranged at a display region, wherein the display region is provided with a first boundary of a curve-like shape, the display region comprises a central region and a peripheral region adjacent to the first boundary, the plurality of subpixels comprises a plurality of first subpixels arranged at the peripheral region and a plurality of second subpixels arranged at the central region, and an aperture ratio of each of at least a part of the first subpixels is smaller than an aperture ratio of any of the second subpixels.

2. The display substrate according to claim 1, wherein an aperture ratio of each of the first subpixels is smaller than an aperture ratio of any of the second subpixels.

3. The display substrate according to claim 1 or 2, wherein a second boundary is arranged between the peripheral region and the central region, and a distance between the second boundary and the first boundary is smaller than a predetermined threshold.

4. The display substrate according to any one of claims 1 to 3, wherein a distance between each first subpixel and the first boundary is smaller than a distance between each second subpixel and the first boundary.

5. The display substrate according to claim 4, wherein the aperture ratios of the first subpixels decrease gradually in a direction from the central region of the display region to the first boundary of the display region.

6. The display substrate according to claim 5, wherein the aperture ratios of the first subpixels decrease gradually in a lengthwise direction of the first subpixels.

7. The display substrate according to claim 5, wherein the aperture ratios of the first subpixels decrease gradually in a widthwise direction of the first subpixels.

8. The display substrate according to claim 5, wherein the first boundary is of an arc-like shape, and the aperture ratios of the first subpixels decrease gradually in a radial direction of the first boundary.

9. The display substrate according to any one of claims 1 to 8, wherein the at least a part of the first subpixels each comprise a light-shielding pattern and at least a transparent region surrounded by the light-shielding pattern.

10. The display substrate according to claim 9, wherein the at least a part of the first subpixels each comprise at least two transparent regions each extending in the lengthwise direction of the first subpixel and spaced apart from each other in the widthwise direction of the first subpixel.

11. The display substrate according to claim 10, wherein widths of the transparent regions of the at least a part of the first subpixels decrease gradually in the direction from the central region of the display region to the first boundary of the display region.

12. The display substrate according to claim 9, wherein the light-shielding pattern is one of a black matrix pattern, a source-drain metal pattern and a gate metal pattern of the display substrate.

13. A method for manufacturing a display substrate, wherein the display substrate comprises a plurality of subpixels arranged at a display region, the display region is provided with a first boundary of a curve-like shape, and the display region comprises a central region and a peripheral region adjacent to the first boundary, wherein the method comprises forming first subpixels at the peripheral region and forming second subpixels at the central region, wherein an aperture ratio of each of at least a part of the first subpixels is smaller than an aperture ratio of any of the second subpixels.

14. A display panel comprising the display substrate according to claim 1.

15. A display device comprising the display panel according to claim 14.
